# EUROPEAN PATENT APPLICATION

(11) **EP 4 791 149 A1**
(43) Date of publication of application: **12.08.2026**
(21) Application number: 24875928.4
(22) Date of filing: 13.03.2024
(51) Int. Cl.: H10F 10/166, H10F 77/30

(54) **HETEROJUNCTION BACK CONTACT BATTERY AND BATTERY ASSEMBLY COMPRISING SAME**

(30) Priority: 08.10.2023 CN 202311298960
(71) Applicant: Trina Solar Co., Ltd, Changzhou, Jiangsu 213031 (CN)
(72) Inventor: CHEN, Daming, Changzhou, Jiangsu 213031 (CN); YANG, Guangtao, Changzhou, Jiangsu 213031 (CN); CHEN, Yifeng, Changzhou, Jiangsu 213031 (CN)
(74) Representative: Casalonga
(86) International application number: PCT/CN2024/081463
(87) International publication number: WO 2025/077099

(57) **Abstract**

This application provides a heterojunction back contact battery and a battery assembly comprising same. The heterojunction back contact battery comprises a silicon substrate, having a first surface and a second surface facing each other, wherein, the first surface is closer to a light receiving surface of the battery and the second surface is closer to a shadow surface of the battery, and the second surface comprises a plurality of adjacent and alternating A sections and B sections; a passivation layer, located between the first surface and the light receiving surface; a tunnel oxide layer and a first thin film layer having a same conductivity type as the silicon substrate, the tunnel oxide layer and the first thin film layer superposed sequentially on the A sections in a direction away from the second surface; and an intrinsic amorphous silicon layer and a second thin film layer having an opposite conductivity type as the silicon substrate, the intrinsic amorphous silicon layer and the second thin film layer superposed sequentially on the B sections in a direction away from the second surface.

## Description

### Technical Field

The present application mainly relates to the field of photovoltaic battery technology, and in particular to a heterojunction back contact battery and a battery assembly comprising same.

### Background

Heterojunction batteries typically consist of ITO conductive film, doped amorphous silicon thin film, and a silicon wafer substrate, combining the advantages of both crystalline silicon and thin-film batteries, they are one of the more popular photovoltaic batteries types in the prior art. Existing heterojunction back contact batteries have very stringent process and operating requirements, how to simplify the battery preparation process and further improv battery performance is a hot topic in this field..

### Summary

The technical problem to be solved by the present disclosure is to provide a heterojunction back contact battery and a battery assembly comprising same, which can improve the passivation effect of the batteries and optimize battery performance.

In order to solve the above technical problems, the present application provides a heterojunction back contact battery, comprising a silicon substrate, having a first surface and a second surface facing each other, wherein, the first surface is closer to a light receiving surface of the battery and the second surface is closer to a shadow surface of the battery, and the second surface comprises a plurality of adjacent and alternating A sections and B sections; a passivation layer, located between the first surface and the light receiving surface; a tunnel oxide layer and a first thin film layer having a same conductivity type as the silicon substrate, the tunnel oxide layer and the first thin film layer superposed sequentially on the A sections in a direction away from the second surface; and an intrinsic amorphous silicon layer and a second thin film layer having an opposite conductivity type as the silicon substrate, the intrinsic amorphous silicon layer and the second thin film layer superposed sequentially on the B sections in a direction away from the second surface.

In one embodiment of the present disclosure, the passivation layer is a single layer consisting of intrinsic amorphous silicon, or a composite layer consisting of tunnel silicon dioxide and polycrystalline silicon thin film.

In one embodiment of the present disclosure, the heterojunction back contact battery further comprises an anti-reflection layer, located above the passivation layer and in a side away from the first surface, and the anti-reflection layer includes one material or a combination of multiple materials selected from silicon nitride, aluminum oxide, and silicon dioxide.

In one embodiment of the present disclosure, a thickness of the tunnel oxide layer is 0.5nm~3 nm.

In one embodiment of the present disclosure, the first thin film layer includes polycrystalline silicon, and a thickness of the first thin film layer is 10nm~300 nm.

In one embodiment of the present disclosure, the second thin film layer includes amorphous silicon, nanocrystalline silicon or polycrystalline silicon, and a thickness of the second thin film layer is 3nm~50nm.

In one embodiment of the present disclosure, the heterojunction back contact battery further comprises a first electrode and a second electrode, wherein, the A section has a first space along a normal direction of the battery in a direction further away from the second surface, and the B section has a second space along the normal direction in a direction further away from the second surface, and the first electrode is located in the first space, the second electrode is located in the second space, wherein the first electrode is directly and only in contact with the first thin film layer in the first space.

In one embodiment of the present disclosure, the intrinsic amorphous silicon layer and the second thin film layer extend from the second space to the first space respectively, the intrinsic amorphous silicon layer and the second thin film layer located in the first space and the second space are intrinsic amorphous silicon segment A, intrinsic amorphous silicon segment B, second thin film segment A and second thin film segment B respectively.

In one embodiment of the present disclosure, the heterojunction back contact battery further comprises an insulating dielectric layer located in the first space, and the tunnel oxide layer, the first thin film layer, the insulating dielectric layer, the intrinsic amorphous silicon segment A and the second thin film segment A are superposed in sequence on the A sections in a direction\further away from the second surface.

In one embodiment of the present disclosure, the insulating dielectric layer comprises one or more of silicon dioxide, doped silicon dioxide, silicon nitride, and silicon oxynitride.

In one embodiment of the present disclosure, the heterojunction back contact battery further comprises a transparent conductive film layer, the transparent conductive film layer extending from the second space into the first space, and the transparent conductive film layers located in the first space and the second space are transparent conductive film segment A and transparent conductive film segment B respectively, wherein, the transparent conductive film segment A locates on a side of the second film segment A further away from the second surface; the transparent conductive film segment B locates on a side of the second film segment B further away from the second surface, and the second electrode is in direct contact with the transparent conductive film segment B.

In one embodiment of the present disclosure, the transparent conductive film layer comprises one or more of ITO, ZnO, copper metal film and aluminum metal film.

In one embodiment of the present disclosure, the first space has a notch penetrating the insulating dielectric layer, the intrinsic amorphous silicon segment A, the second thin film segment A and the transparent conductive film segment A, and a notch width is greater than a width of the first electrode, so that the first electrode in the notch can directly and only contacts the first thin film layer.

Another aspect of the present disclosure also provides a battery assembly, comprising a plurality of heterojunction back contact batteries above-mentioned connected in series and/or in parallel.

Compared with the prior art, the present application has the following advantages: by combining a heterojunction battery with a back-contact battery and setting corresponding sections and a special film layer structure on the back of the battery, the passivation effect of the battery can be improved on the basis of effectively simplifying the preparation process, and the battery can have more optimized performance.

### Brief Description of the Drawings

The drawings are included to provide a further understanding of the present application, and they are included and constitute a part of the present application, the drawings show the embodiments of the present application, and serving to explain the principles of the present application together with the description. In the drawings:

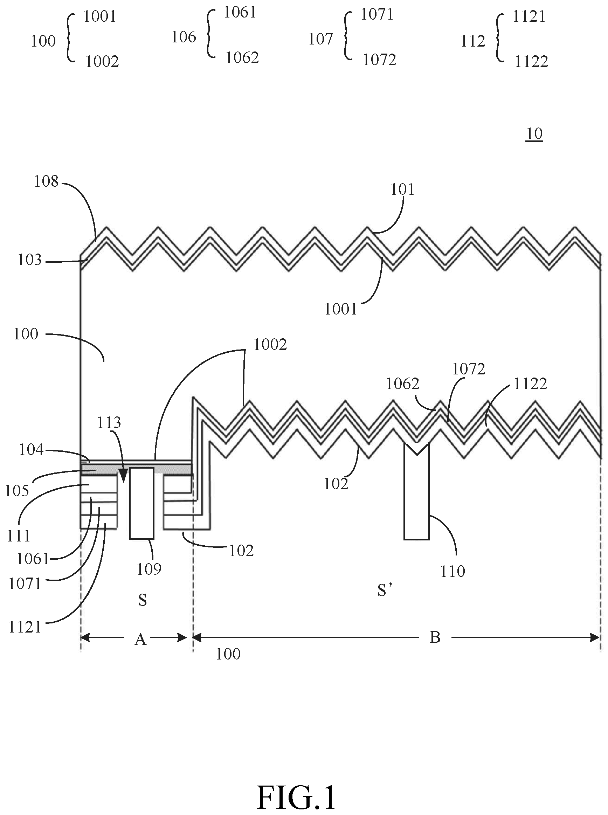

Fig.1 is a schematic structural diagram of a heterojunction back contact battery in one embodiment of the present application.

### Preferred Embodiment of the Present Disclosure

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations " would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

This application proposes a heterojunction back contact battery (hereinafter referred to as battery 10) with reference to Fig.1. The battery 10 comprises a silicon substrate 100, a passivation layer 103, a tunnel oxide layer 104, a first thin film layer 105, an intrinsic amorphous silicon layer 106, a second thin film layer 107, an anti-reflection layer 108, a first electrode 109, and a second electrode 110. In this embodiment, the battery 10 has a light receiving surface 101 and a shadow surface 102, it can be understood that the light receiving surface 101 and the shadow surface 102 can also be understood as the outermost surfaces of the battery 10 facing sunlight and facing away from sunlight respectively, therefore, these two surfaces may have certain morphological variations based on the topography of the battery film and other features. For example, the light receiving surface 101 can be suede structure; while the shadow surface 102 can be a flat surface in one section and a suede structure in the other.

Exemplarily, the silicon substrate 100 has provided a first surface 1001 and a second surface 1002 facing to each other, wherein, the first surface 1001 is closer to the light receiving surface 101 of the battery and the second surface 1002 is closer to the shadow surface 102 of the battery, and the second surface 1002 comprises a plurality of adjacent and alternating A sections and B sections (for the sake of simplicity of the drawing, the A sections and B sections are marked below the entire battery 10 using dotted lines). It can be understood that the second surface 1002 includes a plurality of adjacent and alternating A sections and B sections, and Fig.1 shows one minimum unit that contains A section and B section. Further, to facilitate the subsequent description of the separator layer, it defines the space of the A section along a normal direction of the battery in a direction further away from the second surface as a first space S, and it defines the space of the B section along the normal direction in a direction further away from the second surface as a second space S'. It can be seen that in battery 10, the shadow surface 102 has two electrodes, wherein the first electrode 109 is located in the first space S, the second electrode 110 is located in the second space S'.

Exemplarily, a passivation layer 103 and an anti-reflection layer 108 are sequentially deposited on the first surface 1001, and the passivation layer 103 is immediately below the anti-reflection layer 108 and on a side away from the first surface 1001. In this case, the upper surface of the anti-reflection layer 108 can also be understood as the light receiving surface 101 of the battery 10. In this application, the anti-reflection layer 108 can include one or a combination of silicon nitride, aluminum oxide, and silicon dioxide. In this embodiment, the passivation layer 103 can be a single layer of intrinsic amorphous silicon, or a composite layer of tunneling silicon dioxide and polycrystalline silicon thin film.

Exemplarily, a tunnel oxide layer 104, a first thin film layer 105, an insulating dielectric layer 111, an intrinsic amorphous silicon layer 106, a second thin film layer 107, a transparent conductive film layer 112, a first electrode 109 and a second electrode 110 are sequentially deposited on A section of the second surface 1002.

Specifically, the tunnel oxide layer 104 and the first thin film layer 105 are superposed sequentially on the A sections in a direction away from the second surface, the arrangement order of the two is that the tunnel oxide layer 104 is arranged adjacent to the second surface 1002, and the first film layer 105 is arranged adjacent to the tunnel oxide layer 104. Furthermore, the thickness of the tunnel oxide layer 104 is set to 0.5nm ~ 3 nm in this application, and the thickness of the first thin film layer 105 is set to 10nm ~ 300 nm. Wherein the first thin film layer 105 includes polycrystalline silicon, and the conductivity type of the first thin film layer 105 is the same as that of the silicon substrate 100. It can be clearly seen in Fig. 1 that the first electrode 109 is directly and only in contact with the first thin film layer 105 in the first space S, and does not contact with other layers.

Furthermore, the insulating dielectric layer 111 is also located in the first space S, specifically between the first thin film layer 105 and the intrinsic amorphous silicon layer 106, and the insulating dielectric layer 111 is immediately adjacent between the first thin film layer 105 and the intrinsic amorphous silicon layer 106. In this embodiment, the insulating dielectric layer includes one or more of silicon dioxide, doped silicon dioxide, silicon nitride, and silicon oxynitride.

It should be noted that the intrinsic amorphous silicon layer 106 and the second thin film layer 107 are superposed sequentially on the B sections in a direction away from the second surface, and are sequentially deposited on the second surface 1002 of the silicon substrate 100. For the purpose of simplifying the preparation process, the position of the electrode 109 in this embodiment is obtained by depositing the entire surface of the second surface 1002 and then conducting notched process. It should be noted that due to the notched method, the shadow surface 102 mentioned in this application should be understood as the outermost surface of the entire battery 10, and the position with the notch can be understood as the outermost surface of a complete multi-layer stacked structure above the notched section before the notch is formed. This application should not lead to any inappropriate understanding of the shadow surface of the battery 10 due to the notched structure. Based on this approach, in the battery 10 that finally forms, the intrinsic amorphous silicon layer 106 and the second thin film layer 107 extend from the second space S' to the first space S respectively, wherein the intrinsic amorphous silicon layer 106 located in the first space S is intrinsic amorphous silicon A segment 1061, the intrinsic amorphous silicon layer 106 located in the second space S' is intrinsic amorphous silicon B segment 1062. Wherein, the second thin film layer 107 has an opposite conductivity type to that of the silicon substrate 100, the second thin film layer 107 includes amorphous silicon, nanocrystalline silicon, or polycrystalline silicon, and the thickness of the second thin film layer 107 is in a range of 3 nm ~ 50 nm.

Specifically, a transparent conductive film layer 112 is provided below the second thin film layer 107, the transparent conductive film layer 112 includes one or more types of ITO, ZnO, copper metal film, and aluminum metal film. Similarly, for the purpose of simplifying the preparation process, the transparent conductive film layer 112 also extends from the second space S' into the first space S, and the transparent conductive film layers 112 located in the first space S and the second space S' are transparent conductive film A segment 1121 and transparent conductive film B segment 1122 respectively, wherein, the transparent conductive film A segment 1121 locates on a side of the second film A segment 1071 further away from the second surface, the transparent conductive film B segment 1122 locates on a side of the second film B segment 1072 further away from the second surface, and the second electrode 110 is in direct contact with the transparent conductive film B segment 1122.

In this embodiment, the first space S has a notch 113 penetrating the insulating dielectric layer 111, the intrinsic amorphous silicon segment A 1061, the second thin film segment A 1071 and the transparent conductive film segment A 1121, and a notch width is greater than a width of the first electrode 109, so that the first electrode 109 in the notch 113 can directly and only contacts the first thin film layer 105. In this way, the preparation process can be simplified in the process of obtaining the battery 10, and no electrical connection is formed between section A and section B, thereby avoiding short circuit between the positive and negative electrodes of the battery, and obtaining a battery with better performance.

Exemplarily, this application also provides a battery assembly, which comprises a plurality of heterojunction back contact batteries as described in any one embodiment of this application connected in series and/or in parallel.

The basic concepts have been described above, obviously, for those skilled in the art, the above disclosure of the disclosure is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the disclosure, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A heterojunction back contact battery, **characterized by** comprising:
a silicon substrate, having a first surface and a second surface facing each other, wherein, the first surface is closer to a light receiving surface of the battery and the second surface is closer to a shadow surface of the battery, and the second surface comprises a plurality of adjacent and alternating A sections and B sections;
a passivation layer, located between the first surface and the light receiving surface;
a tunnel oxide layer and a first thin film layer having a same conductivity type as the silicon substrate, the tunnel oxide layer and the first thin film layer superposed sequentially on the A sections in a direction away from the second surface; and
an intrinsic amorphous silicon layer and a second thin film layer having an opposite conductivity type as the silicon substrate, the intrinsic amorphous silicon layer and the second thin film layer superposed sequentially on the B sections in a direction away from the second surface.

2. The heterojunction back contact battery according to claim 1, **characterized in that**, the passivation layer is a single layer consisting of intrinsic amorphous silicon, or a composite layer consisting of tunnel silicon dioxide and polycrystalline silicon thin film.

3. The heterojunction back contact battery according to claim 2, **characterized by** further comprising an anti-reflection layer, located above the passivation layer and in a side away from the first surface, and the anti-reflection layer includes one material or a combination of multiple materials selected from silicon nitride, aluminum oxide, and silicon dioxide.

4. The heterojunction back contact battery according to claim 1, **characterized in that**, a thickness of the tunnel oxide layer is 0.5nm~3 nm.

5. The heterojunction back contact battery according to claim 1, **characterized in that**, the first thin film layer includes polycrystalline silicon, and a thickness of the first thin film layer is 10nm~300 nm.

6. The heterojunction back contact battery according to claim 1, **characterized in that**, the second thin film layer includes amorphous silicon, nanocrystalline silicon or polycrystalline silicon, and a thickness of the second thin film layer is 3nm~50nm.

7. The heterojunction back contact battery according to any one of claims 1 ~ 6, **characterized by** further comprising a first electrode and a second electrode, wherein, the A section has a first space along a normal direction of the battery in a direction further away from the second surface, and the B section has a second space along the normal direction in a direction further away from the second surface, and the first electrode is located in the first space, the second electrode is located in the second space, wherein the first electrode is directly and only in contact with the first thin film layer in the first space.

8. The heterojunction back contact battery according to claim 7, **characterized in that**, the intrinsic amorphous silicon layer and the second thin film layer extend from the second space to the first space respectively, the intrinsic amorphous silicon layer and the second thin film layer located in the first space and the second space are intrinsic amorphous silicon segment A, intrinsic amorphous silicon segment B, second thin film segment A and second thin film segment B respectively.

9. The heterojunction back contact battery according to claim 8, **characterized by** further comprising an insulating dielectric layer located in the first space, and the tunnel oxide layer, the first thin film layer, the insulating dielectric layer, the intrinsic amorphous silicon segment A and the second thin film segment A are superposed in sequence on the A sections in a direction\further away from the second surface.

10. The heterojunction back contact battery according to claim 9, **characterized in that**, the insulating dielectric layer comprises one or more of silicon dioxide, doped silicon dioxide, silicon nitride, and silicon oxynitride.

11. The heterojunction back contact battery according to claim 9, **characterized by** further comprising a transparent conductive film layer, the transparent conductive film layer extending from the second space into the first space, and the transparent conductive film layers located in the first space and the second space are transparent conductive film segment A and transparent conductive film segment B respectively, wherein,
the transparent conductive film segment A locates on a side of the second film segment A further away from the second surface;
the transparent conductive film segment B locates on a side of the second film segment B further away from the second surface, and the second electrode is in direct contact with the transparent conductive film segment B.

12. The heterojunction back contact battery according to claim 11, **characterized in that**, the transparent conductive film layer comprises one or more of ITO, ZnO, copper metal film and aluminum metal film.

13. The heterojunction back contact battery according to claim 11, **characterized in that**, the first space has a notch penetrating the insulating dielectric layer, the intrinsic amorphous silicon segment A, the second thin film segment A and the transparent conductive film segment A, and a notch width is greater than a width of the first electrode, so that the first electrode in the notch can directly and only contacts the first thin film layer.

14. A battery assembly, **characterized by** comprising a plurality of heterojunction back contact batteries as described in claims 1 to 13 connected in series and/or in parallel.
